**Europäisches Patentamt**

**European Patent Office**

**Office européen des brevets**

(19)

(11) Publication number: **0 232 560**
**B1**

(12)

# EUROPEAN PATENT SPECIFICATION

(45) Date of publication of the patent specification:
24.10.90

(51) Int. Cl.⁵: **H03D 7/14**

(21) Application number: **86202184.7**

(22) Date of filing: **01.12.86**

(54) UHF amplifier-mixer circuit.

(30) Priority: **13.12.85 NL 8503435**

(43) Date of publication of application:
**19.08.87 Bulletin 87/34**

(45) Publication of the grant of the patent:
**24.10.90 Bulletin 90/43**

(84) Designated Contracting States:
**DE FR GB IT**

(56) References cited:
**DE-A-3 038 995**
**GB-A-2 064 253**

**PHILIPS DATA HANDBOOK-COMPONENTS AND MATERIALS, Part 2, December 1982, pages 157-171, Eindhoven, NL; "V.H.F./U.H.F. television tuners"**

(73) Proprietor: N.V. Philips' Gloeilampenfabrieken,
Groenewoudseweg 1, NL-5621 BA Eindhoven(NL)

(72) Inventor: Schreurs, Peter Henricus Marie, c/o INT.
OCTROOIBUREAU B.V. Prof. Holstlaan 6, NL-5656 AA
Eindhoven(NL)

(74) Representative: Schoonheijm, Harry Barend et al,
INTERNATIONAAL OCTROOIBUREAU B.V.
Prof.Holstlaan 6, NL-5656 AA Eindhoven(NL)

## Description

The invention relates to a UHF amplifier-mixer circuit.

The VHF/UHF tuner UV 413/414, published in "Philips Data Handbook - Components and Materials", part 2, December 1982, pages 157-171 comprises a UHF amplifier-mixer circuit in which a UHF TV signal is amplified in a UHF preliminary stage and subsequently additively mixed in a mixer diode with a tuning oscillator signal. Such an additive amplifier-mixer circuit cannot easily be realized in integrated form and has inter alia a worse mixing efficiency and greater oscillator radiation than a multiplicative amplifier-mixer circuit in which the mixer part is arranged in cascode with the amplifier part, as is known, for example, from the German published Patent Application DE-A 3 038 995. For processing signals in the TV-UHF range (approximately 400-900 MHz) such prior art multiplicative amplifier-mixer circuits are, however, less suitable because large noise and/or signal distortion generally occurs therein, which is inadmissible for such high signal frequencies.

The invention has for its object to provide a UHF amplifier-mixer circuit which can be realized in integrated form in a simple manner and in which both a linear gain of a UHF-TV signal and a low-noise multiplicative mixing of the amplified UHF-TV signal with a comparatively small tuning oscillator signal is possible.

To this end a UHF amplifier-mixer circuit according to the invention is characterized by a balanced transistor pair in long-tail configuration having a base input for receiving an oscillator signal, a collector output and interconnected emitter electrodes, which are coupled to the collector output of a UHF amplifier transistor provided with an input electrode for receiving a UHF input signal, said emitter electrodes being connected to a supply voltage via a fixed shunt path for conveying a constant part of the direct current for the UHF amplifier transistor from the supply voltage.

The use of a variable shunt in a multiplicative amplifier mixer circuit for automatic gain control is known per se from United States Patent US-A 4 388 540. The noise behaviour of the amplifier-mixer circuit within the gain control range is, however, unimportant.

The invention is based on the recognition that for a low-noise mixing of signals in the UHF range with a small oscillator signal the current through the mixer part of a multiplicative amplifier-mixer circuit is to be considerably smaller than the bias current which is required to obtain a linear gain of such signals in the amplifier part arranged in cascode with the mixer part.

When the measure according to the invention is used the shunt path provides a degree of freedom so that the current setting of the mixer part in the aforementioned multilplicative amplifier-mixer circuit is decoupled from the current setting of the amplifier part and that it becomes possible to realise both a linear and hence distortion-freegain of UHF-TV signals and a low-noise multiplicative mixing of such radio frequency signals with a comparatively small oscillator signal.

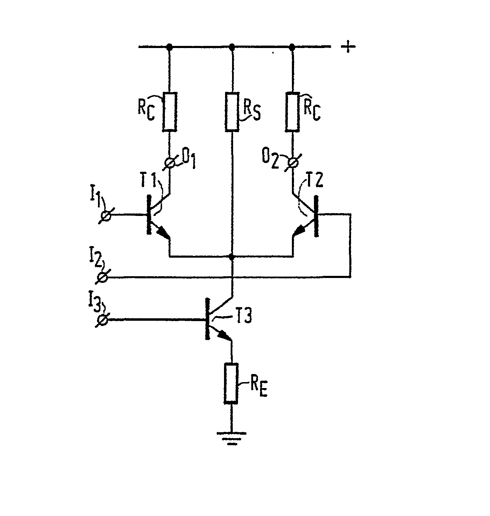

The invention will be further described with reference to an embodiment of a UHF amplifier-mixer circuit according to the invention as is shown in the sole Figure of the drawing.

The UHF amplifier-mixer circuit shown in this Figure comprises a balanced transistor pair T1,T2 in a long0tail configuration whose emitters are jointly coupled to the collector of a UHF amplifier transistor T3. In the embodiment shown the transistor T3 is arranged in a common emitter configuration in which the base as an input electrode constitutes a UHF signal input $I_3$ of the UHF amplifier-mixer circuit and the emitter is connected to ground via an emitter resistor $R_E$. The base input for the transistor pair T1,T2 constitutes a balanced oscillator input $I_1,I_2$ and the collector output constitutes a balanced intermediate-frequency output 01,02 of the UHF amplifier-mixer circuit shown. This collector output is connected to a supply voltage via a balanced output load shown by means of two collector resistors $R_C$ of mutually equal value. A fixed shunt path incorporating a shunt resistor $R_S$ through which a constant part of the d.c. bias for the UHF amplifier transistor T3 is obtained from the supply voltage without passing through the transistor pair T1,T2 is arranged between the coupled emitters of the transistor pair T1,T2 and the supply voltage.

The gain of the UHF amplifier transistor is linearised and consequently distortion-free by using a negative emitter feedback via the emitter-resistor $R_E$ on the one hand and a comparatively high bias current on the other hand.

The UHF-TV signal thus linearly amplified in T3 is subsequently mixed multiplicatively in the transistor pair T1,T2 with a balanced oscillator signal applied to the oscillator input $I_1,I_2$. With a suitable value of the shunt resistor $R_S$ a gain factor of the UHF amplifier-mixer circuit can be achieved which as a whole remains acceptably high on the one hand and that a sufficiently large part of the d.c. bias is shortcircuited from the transistor T3 to the supply voltage on the other hand in order to reduce the current applied to the transistor pairT1,T2 in such manner that a comparatively small oscillator signal will, suffice for a rapid and hence low-noise change-over of this current in the transistor pair T1,T2.

In a practical embodiment the transistors T1-T3 were of the V2305 type and the resistors $R_C$, $R_E$ and $R_S$ had values of: 500Ω, 50Ω and 4 kΩ respectively. The bias current through the UHF amplifier transistor T3 was 5mA and that through the balanced transistor pair T1,T2 was 3.5 mA.

It stands to reason that it is also possible within the scope of the inventive idea to arrange the transistor T3 in a common base configuration (not shown) and to choose the emitter as an input electrode to which the UHF input signal is applied. The UHF signal source to be connected to the emitter should then preferably have a high source impedance for a linear gain. A practical value is 100 Ohms at 860 MHz.

## Claims

1. A UHF amplifier-mixer circuit characterized by a balanced transistor pair ($T_1$, $T_2$) in long-tail configuration having a base input ($I_1$, $I_2$) for receiving an oscillator signal, a collector output (0, $0_2$) and interconnected emitter electrodes, which are coupled to the collector output of a UHF amplifier transistor ($T_3$) provided with an input electrode ($I_3$) for receiving a UHF input signal, said emitter electrodes being connected to a supply voltage via a fixed shunt path ($R_s$) for conveying a constant part of the direct current for the UHF amplifier transistor from the supply voltage.

2. A UHF amplifier-mixer circuit as claimed in Claim 1, characterized in that the shunt path includes a fixed resistor ($R_s$).

## Patentansprüche

1. UHF-Verstärker-Mischschaltung gekennzeichnet durch ein Gegentakt-Transistorpaar ($T_1$, $T_2$) in Langschwanzschaltung mit einem Basiseingang ($I_1$, $I_2$) zum Erhalten eines Oszillatorsignals, einem Kollektorausgang ($0_1$, $0_2$) sowie miteinander verbundenen Emitterelektroden, die mit dem Kollektorausgang eines UHF-Verstärkertransistors ($T_3$) verbunden sind, der mit einer Eingangselektrode ($I_3$) versehen ist zum Erhalten eines UHF-Eingangssignals, wobei diese Emitterelektroden über eine feste Überbrückungsstrecke ($R_s$) mit einer Speisespannung verbunden sind, und zwar zum Transportieren eines konstanten Teils des Gleichstromes für den UHF-Verstärkertransistor von der Speisespannung.

2. UHF-Verstärkermischschaltung nach Anspruch 1, dadurch gekennzeichnet, daß die Überbrückungsstrecke einen festen Widerstand ($R_s$) aufweist.

## Revendications

1. Circuit amplificateur-mélangeur UHF, caractérisé par une paire de transistors équilibrée ($T_1$, $T_2$) en une configuration à longue queue comportant une entrée de base ($I_1$, $I_2$) destinée à recevoir un signal d'oscillateur, une sortie de collecteur ($0_1$, $0_2$) et des électrodes d'émetteurs interconnectées, qui sont couplées à la sortie de collecteur d'un transistor amplificateur UHF ($T_3$) pourvu d'une électrode d'entrée ($I_3$) destinée à recevoir un signal d'entrée UHF, les électrodes d'émetteurs étant connectées à une tension d'alimentation par l'intermédiaire d'un trajet shunt fixe ($R_s$) afin de transporter une fraction constante du courant continu pour le transistor amplificateur UHF à partir de la tension d'alimentation.

2. Circuit amplificateur-mélangeur UHF suivant la revendication 1, caractérisé en ce que le trajet shunt comprend une résistance fixe ($R_s$).